# EUROPEAN PATENT SPECIFICATION

(11) **EP 3 477 663 B1**
(45) Date of publication and mention of the grant of the patent: **03.12.2025**
(21) Application number: 17814591.8
(22) Date of filing: 06.06.2017
(51) Int. Cl.: H01B 13/00, C23C 16/26, C23C 16/44, C01B 32/162, C01B 32/164, C01B 32/186, C01B 32/159

(54) **SINGLE-WALLED CARBON NANOTUBE FLEXIBLE TRANSPARENT CONDUCTIVE THIN FILM WITH CARBON WELDED STRUCTURE AND PREPARATION METHOD THEREFOR**
FLEXIBLE TRANSPARENTE LEITFÄHIGE DÜNNSCHICHT AUS EINWANDIGEN KOHLENSTOFFNANORÖHRCHEN MIT GESCHWEISSTER KOHLENSTOFFSTRUKTUR UND HERSTELLUNGSVERFAHREN DAFÜR
FILM MINCE CONDUCTEUR TRANSPARENT FLEXIBLE DE NANOTUBES DE CARBONE MONOPAROI AVEC STRUCTURE SOUDÉE AU CARBONE ET SON PROCÉDÉ DE PRÉPARATION

(30) Priority: 22.06.2016 CN 201610459221
(43) Date of publication of application: 01.05.2019
(73) Proprietor: Institute of Metal Research Chinese Academy of Sciences, Shenyang, Liaoning 110016 (CN)
(72) Inventor: HOU, Pengxiang, Shenyang Liaoning 110016 (CN); JIANG, Song, Shenyang Liaoning 110016 (CN); LIU, Chang, Shenyang Liaoning 110016 (CN); CHENG, Huiming, Shenyang Liaoning 110016 (CN)
(74) Representative: ZHAOffice SPRL
(86) International application number: PCT/CN2017/087254
(87) International publication number: WO 2017/219853

(56) References cited:
- CN-A- 102 173 406
- CN-A- 102 643 638
- CN-A- 103 204 492
- CN-A- 104 445 139
- CN-B- 103 031 531
- KR-A- 20070 050 617
- US-A1- 2005 006 801
- US-A1- 2008 175 984
- CHUNYAN LI ET AL: "Graphene Nano-"patches" on a Carbon Nanotube Network for Highly Transparent/Conductive Thin Film Applications", JOURNAL OF PHYSICAL CHEMISTRY C, vol. 114, no. 33, 4 August 2010 (2010-08-04), pages 14008 - 14012, XP055594565, ISSN: 1932-7447, DOI: 10.1021/jp1041487

## Description

### Background of the Present Invention

### Field of Invention

The present invention the field of preparation of a high performance flexible transparent conductive film, and particularly relates to a single-walled carbon nanotube flexible transparent conductive thin film with carbon welded structure and its preparation method thereof.

### Description of Related Arts

The transparent conductive film is an important component of electronic devices such as touch screens, flat panel displays, photovoltaic cells, and organic light emitting diodes. At present, indium tin oxide (ITO) is the most mature transparent conductive film for commercial applications. However, the scarcity of rare metal indium makes the cost of ITO increase gradually. On the other hand, with the rise of flexible electronics, the brittleness of ITO cannot meet the future application. Due to its good optoelectronic properties, structural stability, flexibility and other characteristics, the two-dimensional network transparent conductive film interwoven with single-walled carbon nanotubes with its high transparent conductivity and excellent flexibility is expected to replace the scarce and brittle indium tin oxide as a new generation of transparent conductive film and is widely used.

At present, there are mainly two methods for preparing a single-walled carbon nanotube flexible transparent conductive film. One is a wet method (solution method), in which a single-walled carbon nanotube is first dispersed in a solution, and then a single-walled carbon nanotube is deposited on a flexible substrate by filtration, spraying, suspension coating or printing. The limitation of this method is that the physical and chemical processes of dispersing single-walled carbon nanotubes can destroy the intrinsic structure of the carbon nanotubes, introduce pollutants such as surfactants, and thereby reduce the performance of the obtained transparent conductive film. The other method is a dry method in which a collecting device is installed at the end of the reaction system for growing single-walled carbon nanotubes, and the grown single-walled carbon nanotubes are directly collected on the porous substrate; and the carbon nanotubes are transferred to a flexible substrate by an imprint process to form a transparent conductive film. (Document 1: Kaskela A, Nasibulin A G, Timmermans M Y, et al. Aerosol-synthesized SWCNT networks with tunable conductivity and transparency by a dry transfer technique[J]. Nano letters, 2010, 10(11): 4349-4355.) This method has the advantages of maintaining the intrinsic structure of the carbon nanotubes and does not introduce pollution, and is low in consumption and simple, which is easy to large-scale production. Therefore, a series of development, such as reducing tube bundle size, reducing contact resistance, patterning, etc., have been made in the dry preparation of carbon nanotube transparent conductive films (Document 2: Mustonen K, Laiho P, Kaskela A, et al. Uncovering the ultimate performance of single-walled carbon nanotube films as transparent conductors[J]. Applied Physics Letters, 2015, 107(14): 143113. Document 3: Fukaya N, Kim D Y, Kishimoto S, et al. One-step sub-10 µm patterning of carbon-nanotube thin films for transparent conductor applications[J]. ACS nano, 2014, 8(4): 3285-3293).

It has been reported that the photoelectric properties of single-walled carbon nanotube transparent conductive films obtained by dry transfer (sheet resistance greater than 200 Ω / □ (ohm / sq) @ 90% transmittance) are not comparable to those of ITO (less than 50Ω/□ @ 90% transmittance), and are much lower than those predicted based on single-walled single-walled carbon nanotubes. This is mainly because the commonly produced single-walled carbon nanotubes are aggregated into bundles of ten to several tens of nanometers in diameter due to the strong van der Waals force between the tubes, and the single-walled carbon nanotubes in the tube bundle do not contribute to the conductivity of the film but absorb a large amount of light, thus reducing the photoelectric properties of the film. (Document 4: Radosavljević M, Lefebvre J, Johnson A T. High-field electrical transport and breakdown in bundles of single-wall carbon nanotubes[J]. Physical Review B, 2001, 64(24): 241307.) Kauppinen et al. reduced the yield of carbon nanotubes by reducing the amount of catalyst supplied, and obtained single-walled carbon nanotubes with a single root ratio of more than 50%. The best photoelectric performance of the prepared transparent conductive film is 310 Ω / □ @ 90% transmittance. (Document 2: Mustonen K, Laiho P, Kaskela A, et al. Uncovering the ultimate performance of single-walled carbon nanotube films as transparent conductors[J]. Applied Physics Letters, 2015, 107(14): 143113.) On the other hand, due to the nanometer size of single-walled carbon nanotubes, the contact resistance between the tubes is considered to be a major contributor to the sheet resistance. Researchers usually use nitric acid doping to reduce the contact resistance between carbon nanotubes. (Document 5: Jackson R, Domercq B, Jain R, et al. Stability of doped transparent carbon nanotube electrodes[J]. Advanced Functional Materials, 2008, 18(17): 2548-2554.) However, this chemical doping effect is not stable, resulting in a gradual rise in sheet resistance.

In the article "Graphene Nano-"patches" on a Carbon Nanotube Network for Highly Transparent/Conductive Thin Film Applications" J. Phys. Chem. C 2010, 114, 14008-14012 Chunyang Li et al describe free standing carbon based thin films consisting of a carbon nanotube network patched with graphene sheets.

Chinese Patent application CN 103 204 492 discloses a method for improving the yield of a single-walled carbon nanotube, which is implemented mainly on the basis of a floating catalytic cracking process, wherein the floating catalytic cracking process comprises the steps of leading a carbon source and a catalyst into a high temperature reaction zone through a carrier gas, and synthesizing the single-walled carbon nanotube at a selected temperature, wherein according to the new method, the selected temperature is increased to 1000-1400 DEG C, preferably 1200-1350 DEG C.

### Summary of the Present Invention

An object of the present invention is to provide a single-walled carbon nanotube flexible transparent conductive film with carbon welded structure and its preparation method thereof so as to solve the key problems of single-walled carbon nanotubes aggregated to absorb large amounts of light and reduce contact resistance between tubes and to obtain a single-walled carbon nanotube flexible transparent conductive film with comparable performance to flexible ITO and high stability.

The present invention is implemented by the following technical solutions:

A single-walled carbon nanotube flexible transparent conductive thin film with carbon-welded structure, that a highly crystalline graphene *sp²* carbon island is constructed to cover a connecting junction between single-walled carbon nanotubes, wherein the graphene *sp²* carbon island is welded at the intersection between individual single-walled carbon nanotubes, forming a single-walled carbon nanotube film having a *sp²* carbon island welded structure; in a single-walled carbon nanotube network wherein in the single-walled carbon nanotube network, the proportion of single carbon nanotubes is 80-88% and the connecting portion of the single carbon nanotubes is tightly connected through carbon welded structure and in the single-walled carbon nanotube flexible transparent conductive thin film with carbon-welded structure, the crystalline IG/ID of graphene carbon islands and single-walled carbon nanotubes in the carbon-welded structure is 150~180, the *sp²* C-C bond ratio is 97 to 99%, and the oxidation temperature exceeds 750-800°C.

In the single-walled carbon nanotube flexible transparent conductive thin film with carbon-welded structure, the single-walled carbon nanotubes have a length of 10 ~ 200µm and a diameter of 1.4 ~ 2.4nm.

A preparation method of the single-walled carbon nanotube flexible transparent conductive thin film with carbon-welded structure, which uses volatile metal organic compound ferrocene as a catalyst precursor, sulfur-containing organic compound thiophene as a growth promoter, hydrocarbon ethylene and toluene as carbon source, hydrogen as a carrier gas to grow carbon nanotubes under 1100°C in a reaction furnace, and the high-quality single-walled carbon nanotube flexible transparent conductive thin film is collected in situ at the end of a furnace tube of the reaction furnace wherein ethylene is mixed with carrier gas hydrogen and toluene being mixed with ferrocene and thiophene , wherein the preparation method of the single-walled carbon nanotube flexible transparent conductive thin film with carbon-welded structure comprises the steps of:
(1) Under the protection of argon gas, a temperature of the reactor furnace is first increased to 1100±50°C, then a carrier gas hydrogen and a main carbon source ethylene are introduced;
(2) Being carried by the carrier gas, supplying a solution consisting of auxiliary carbon source toluene, catalyst precursor ferrocene and growth promoter thiophene by an injection pump which then volatilizes and enters into a 1100±50°C high temperature zone; ferrocene and thiophene being cleaved to form catalyst particles, ethylene and toluene being cracked to carbon atoms under catalysis of the catalyst and nucleating on the catalyst particles and growing the single-walled carbon nanotubes;
(3) the single-walled carbon nanotubes flowing along a gas flow to the end of the furnace tube, and finally being filtered by a porous filter positioned at the end of the furnace tube to form a macroscopic two-dimensional carbon nanotube thin film.

According to the preparation method of the single-walled carbon nanotube flexible transparent conductive thin film with carbon-welded structure, in the process of growing single-walled carbon nanotubes by floating catalyst chemical vapor deposition, through reducing a concentration of the catalyst and the carbon source and a staying time in a constant temperature zone, a portion of carbon source being decomposed by the catalyst form *sp²* carbon islands, which is welded at an intersection between individual single-walled carbon nanotubes such that a single-walled carbon nanotube film having a *sp²* carbon island welded structure is finally formed; before and after the preparation method, the flow rate of argon gas is 180~220 ml/min; during the preparation method, the flow rate of hydrogen is 4500~8000ml/min, the flow rate of ethylene is 2~20ml/min, and the supply rate of the solution is 0.1 ~ 0.24ml/hr, the solution formulation is toluene: ferrocene: thiophene = 10g: (0.05~0.6)g: (0.025~0.9)g.

According to the single-walled carbon nanotube flexible transparent conductive thin film with carbon-welded structure, imprinting method is used to transfer the carbon nanotube thin film to a flexible substrate to construct the flexible transparent conductive thin film.

According to the single-walled carbon nanotube flexible transparent conductive thin film with carbon-welded structure, the flexible substrate is polyethylene terephthalate, polyethylene naphthalate or polycarbonat.

According to the single-walled carbon nanotube flexible transparent conductive thin film with carbon-welded structure, the single-walled carbon nanotube flexible transparent conductive thin film has excellent uniformity with a standard error in the transmittance of ±0.4% and a standard error in the sheet resistance of ±4.3%.

The design idea of the present invention is:
The invention utilizes the difference in decomposition temperature between the gas phase carbon source and the liquid phase carbon source to realize the decomposition of the carbon source in the medium-high temperature to high temperature range in the reaction system, thereby inhibiting the agglomeration and growing of the catalyst particles or poisoning by excessive adsorption of carbon.

Through using very low carbon source and catalyst concentration to reduce the number of nucleation of carbon nanotubes, thus reducing the chance of contact between carbon nanotubes and tube bundles formation; through the use of high carrier gas flow rate to reduce the staying time of the catalyst and the carbon source in the growing zone, so that some carbon atoms cannot participate in the growth of the carbon nanotubes in time to form a highly crystalline graphene carbon islands. Under the combined action of thermal motion and van der Waals force, some of the graphene carbon islands are adsorbed on the surface of the carbon nanotubes, thereby suppressing the formation of tube bundles. Due to the filtration of the porous membrane, the carbon nanotubes are deposited and overlap each other on the surface of the membrane. As the reaction progresses, the graphene carbon islands in the gas stream are deposited at the connecting junction between individual tubes, then a graphene island welded structure is formed eventually. In the high-performance flexible single-walled carbon nanotube film welded by graphene islands, the first function of the graphene island welding structure is to reduce the contact resistance between the carbon nanotubes, and the second function is to solve the problem of large absorption of light caused through suppressing tube aggregation and bundling.

The advantages and benefits of the present invention are:
1. The invention designs and prepares a carbon-welded single-walled carbon nanotube flexible transparent conductive thin film for the first time, which effectively solves the problem of large contact resistance between tubes and large amount of light absorbed by tube bundles in conventional single-walled carbon nanotube films.
2. The single-walled carbon nanotube flexible transparent conductive thin film with carbon-welded structure of the present invention has a sheet resistance of only 41 Ω/□ at 90% transmittance (550 nm visible light).; at the same transmittance, the sheet resistance is 5.5 times lower than that of the lowest reported value of the conventional the undoped original carbon nanotube transparent conductive film, and is at the same level as the optimal performance of the flexible substrate ITO transparent conductive film.
3. The preparation method of the single-walled carbon nanotube flexible transparent conductive thin film with carbon-welded structure of the present invention has the characteristics of simple process and easy to large-scale production, thus solving the key scientific and technical problems of poor stability and complicated process of carbon nanotube transparent conductive film; that it is expected to play an important role in the fields of touch screen, liquid crystal display and organic light display.
4. In the process of growing single-walled carbon nanotubes by floating catalyst chemical vapor deposition of the present invention, through reducing a concentration of the catalyst and the carbon source and a staying time in a constant temperature zone, a portion of carbon source being decomposed by the catalyst form *sp²* carbon islands, which is then welded at an intersection between individual single-walled carbon nanotubes and a single-walled carbon nanotube film having a *sp²* carbon island welded structure is finally formed.
5. The invention designs and prepares a single carbon nanotube bonded by a carbon welding structure, thus reducing the contact resistance between the carbon nanotubes, inhibiting the formation of the tube bundle and absorption of a large amount of light, and obtaining a high-performance flexible transparent conductive film. Therefore, the present invention is of great significance for the application of carbon nanotube film in the field of high performance optoelectronic devices.

### Brief Description of the Drawings

FIG. 1: Single-walled carbon nanotube film preparation system. In the figure, 1 refers to reaction furnace; 2 refers to precision injection pump; 3 refers to temperature controller.
FIG. 2: SEM characterization of the 1# sample. (a)-(b) are high- and low-magnification SEM images of the sample respectively; (c) is the length chart of the carbon nanotubes in the sample.
FIG. 3: TEM, Raman spectroscopy, XPS and heat treatment characterization results for 1# sample. (a) is a low- and high-power transmission electron micrograph of the sample; (b) is a statistical graph of the number of individual carbon nanotubes contained in a single bundle of tubes in the sample; (c) is a TEM diameter diagram of the carbon nanotubes in the sample (d) is the Raman spectrum G-mode and D-mode diagram of the sample; (e) is the X-ray photoelectron spectroscopy of the sample; (f) is a transmission electron micrograph of the air heat treatment at 700°C for 30 minutes.
FIG. 4: Results of the uniformity of the 1# sample. (a) is an optical photograph of a carbon nanotube transparent conductive film of marked sheet resistance and transmittance transferred to a transparent flexible substrate; (b) is a schematic diagram of uniformity of the diagram (a).
FIG. 5: Results of the performance stability test for the #1 sample. (a) is the performance stability map of carbon nanotube film doped with or without nitric acid in air; (b) is the comparison of repeated bending test results (bending angle of 70°) of single-walled carbon nanotube film and commercial ITO (PET base); (c) Comparison of single large angle bending test results (bending angle of 180°) of the original sample and commercial ITO (PET base).
FIG. 6: TEM photograph of the 2# sample. (a)-(b) are low- and high-power TEM images of the sample respectively.

### Detailed Description of the Preferred Embodiment

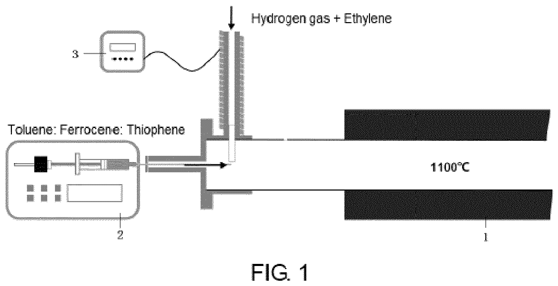

Referring to FIG. 1 of the drawings, a single-walled carbon nanotube thin film preparation system mainly comprises a reaction furnace 1, a precision injection pump 2, a temperature controller 3. The reaction furnace 1 is connected to the precision injection pump 2. The precision injection pump 2 injects the raw materials toluene, ferrocene and thiophene into the reaction furnace 1. At the same time, a mixed gas of hydrogen and ethylene is input into the reaction furnace 1 through a pipeline. The temperature controller 3 is provided at an outer side of the pipeline.

In the process of a specific embodiment of the present invention, the present invention adopts injection floating catalyst CVD method to control the preparation of the carbon-welded single-walled carbon nanotube flexible transparent conductive film. The volatile metal organic compound ferrocene is used as a catalyst precursor, the sulfur-containing organic compound thiophene is a growth promoter, the hydrocarbon ethylene and toluene are carbon sources, the hydrogen is a carrier gas. The carbon nanotubes are grown at 1100°C and the high-quality single-walled carbon nanotube flexible transparent conductive film is collected in situ at the end of the furnace tube. The particular steps are as follows:
(1) Under the protection of argon gas, the temperature of the reactor furnace is first increased to 1100°C, then the carrier gas hydrogen and the main carbon source ethylene are introduced;
(2) Being carried by the carrier gas, the solution supplied by the injection pump (including auxiliary carbon source toluene, catalyst precursor ferrocene and growth promoter thiophene) volatilizes rapidly and enters into the high temperature zone (1100°C); ferrocene and thiophene are cleaved to form catalyst particles, under the catalysis of the catalyst, ethylene and toluene crack out carbon atoms, and nucleating and growing single-walled carbon nanotubes on the catalyst particles;
(3) Carbon nanotubes flow along the gas flow to the end of the furnace tube, and is finally filtered by the porous filter positioned at the end of the furnace tube to form a macroscopic two-dimensional carbon nanotube film, thus realizing in-situ gas phase collection of carbon nanotube film on porous substrate; if the collection time is different, the resulting film thickness is different.
(4) At the end of the preparation method, the reaction furnace and the temperature controller start to cool down, the injection pump stops working, the supply of hydrogen and ethylene is stopped, and then argon gas is introduced to discharge the gas in the reaction tube.

Wherein before and after the preparation method, the flow rate of argon gas is 200 ml/min; during the preparation method, the flow rate of hydrogen is 4500-8000 ml/min, the flow rate of ethylene is 2-20 ml/min, and the supply rate of the solution is 0.1-0.24 ml/hr. the solution formulation is toluene: ferrocene: thiophene = 10g: (0.05 ~ 0.6) g: (0.025 - 0.9) g.

According to the high-performance single-walled carbon nanotube flexible transparent conductive film obtained by the present invention, a highly crystalline graphene carbon island is designed and covered at the connecting junction of the singled-walled carbon nanotube, this carbon island structure solves the problem of large-scale absorption of light by single-walled carbon nanotubes and the large contact resistance between carbon nanotubes due to van der Waals force, and finally a high performance flexible transparent single-walled carbon nanotube conductive film is obtained. The proportion of single carbon nanotubes in a single-walled carbon nanotube network can achieve as high as 85%. This avoids the problem that the tube bundle (the tube bundle size is usually tens of nanometers) absorbs a large amount of light in the conventional single-walled carbon nanotube network and the carbon nanotube inside the tube bundle does not contribute to the conductivity. The carbon-welded structure tightly connects the junction between the carbon tubes, hence greatly reducing the joint resistance between the carbon tubes. The carbon islands and the single-walled carbon nanotubes in carbon welded structures are highly crystalline (IG/ID is 175, sp2 C-C bond ratio is 98.8%, and oxidation temperature exceeds 700°C), the length of the carbon nanotubes is long (10 to 200µm) and the diameter the carbon nanotubes is great (1.4 ~ 2.4 nm). By mounting a porous substrate at the end of the furnace tube for in-situ collection of carbon nanotube film, not only the complicated subsequent solution treatment of dispersion film forming and the introduction of impurities are eliminated, but also the integrity of the intrinsic structure of the carbon nanotubes is ensured.

The present invention can utilize a simple imprint method to transfer the carbon nanotube film to the flexible substrate (For example, polyethylene terephthalate (PET), polyethylene naphthalate (PEN), polycarbonate (PC), etc.) and constructing a flexible transparent conductive film. The film has a sheet resistance of only 41 Ω/□ at 90% transmittance (550 nm visible light). At the same transmittance, the sheet resistance of the undoped original carbon nanotube transparent conductive film is 5.5 times lower than the lowest reported value of the conventional pure carbon nanotube transparent conductive film, reaching the level of commercial ITO flexible film. The resulting single-walled carbon nanotube film has excellent uniformity (light transmittance error is ±0.4%, sheet resistance error is ±4.3%), air stability, high temperature and high humidity stability. Also, good performance stability is maintained after repeated bending and single large angle bending test.

Among the products obtained by the method of the present invention, evaluation of the high performance characterization technique for the single-walled carbon nanotube transparent conductive film includes: Photoelectric performance test, air stability test, accelerated aging test, repeated bending test and single bending test.

The present invention is further described in detail below with the exemplary embodiment and accompanying figures.

### Embodiment 1

According to this embodiment, under the protection of argon gas at a flow rate of 200ml/min, the temperature of the reactor is first increased to 1100°C, then hydrogen gas, carbon source, catalyst precursor ferrocene and growth promoter thiophene are introduced at a flow rate of 8060 ml/min. Wherein the volume concentration of ethylene in the gas phase carbon source is 1.4x10⁻³ in the reaction system, the volume concentration of toluene in the reaction system is 6.1x10⁻³, and the volume concentration of the catalyst precursor ferrocene in the reaction system is 1.5x10⁻⁶, and the volume concentration of the growth promoter thiophene in the reaction system is of 5x10⁻⁷. The carbon nanotubes being produced flow along the gas flow to the end of the furnace tube, and a macroscopic two-dimensional carbon nanotube film is finally formed on the porous filter positioned at the end of the furnace tube to form. Through controlling the collection time, the films with different light transmittances are obtained.

A sample of the single-walled carbon nanotube film prepared as described above (labeled as 1#) is used for characterization tests of TEM, Raman spectroscopy, X-ray photoelectron spectroscopy, scanning electron microscopy, sheet resistance, transmittance, and also for high temperature heat treatment, air stability, accelerated aging, repeated bending and single large angle bending tests.

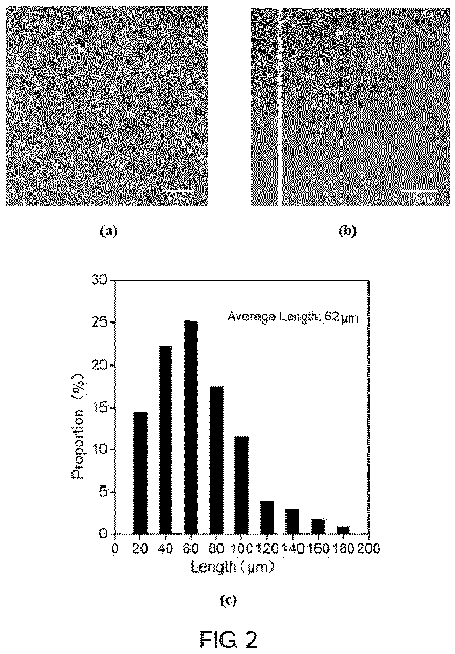

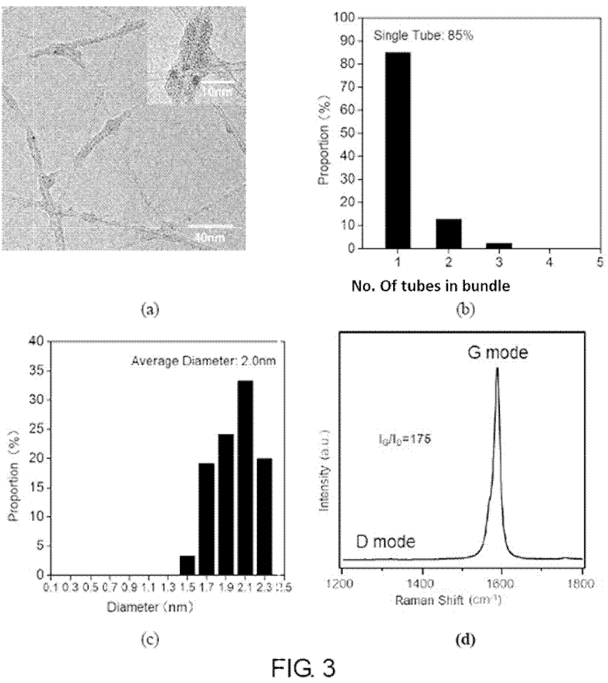

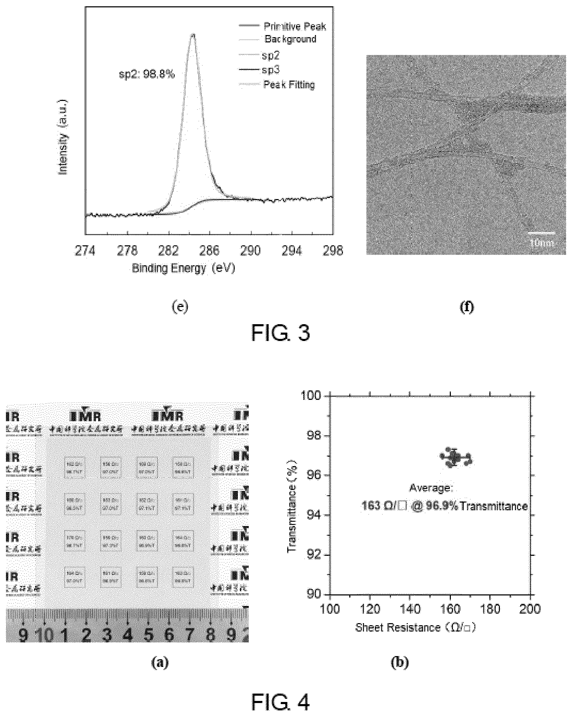

Scanning electron microscopy (FIG. 2) revealed that the carbon nanotubes are long and straight, with an average length of 62µm. Transmission electron micrograph (FIG. 3) shows that the carbon nanotubes in the film are covered with graphene islands, forming a single-walled carbon nanotube network structure welded by graphene islands; wherein 85% of the single-walled carbon nanotubes are single, the other 15% are small bundles with two or three tubes, and bundles with more number of tubes are not found; the diameter of the single-walled carbon nanotubes is 1.4 to 2.4 nm (FIG. 3). The Raman spectrum of a single-walled carbon nanotube film (FIG. 3) has a very high-strength G-mode and a very low-intensity D-mode (IG/ID is 175, IG/ID reported in the literature is usually less than 50) and this shows that the single-walled carbon nanotubes and graphene islands in the film is highly crystalline; at the same time, the X-ray photoelectron spectroscopy (FIG. 3) shows that the *sp*²C-C structure ratio is 98.8%, which also proves the high crystallinity of the film. The carbon-welded structure film is oxidized in air at 700°C for half hour before being characterized by transmission electron microscopy and the results show that almost no change is observed in the carbon welding structure and the single-walled carbon nanotube structure, which further proves that the film obtained has high crystallinity.

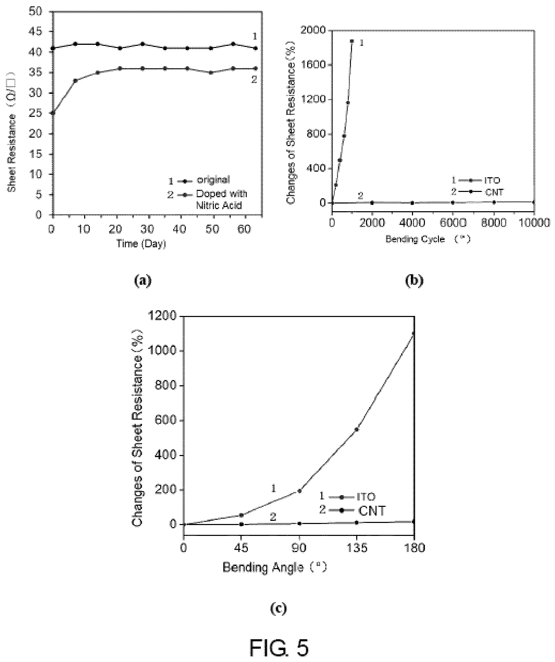

Transfer the collected carbon-welded single-walled carbon nanotube film to the flexible PET substrate by imprinting, the measured film sheet resistance of 90% transmittance (550 nm visible light) is only 41 Ω/□. Also, the film has excellent uniformity: the uniformity of a film of 8x8cm² is tested (FIG. 4), the film transmittance error is ±0.4%, and the sheet resistance error is ±4.3%. The film also has good stability: after being placed in the air for more than 60 days, the sheet resistance changes by less than 2% (FIG. 5), which show a sharp contrast to the film doped with nitric acid. After 250 hours of accelerated aging test, the sheet resistance value only changes by less than 5% (Table 1). After bending experiments for 10,000 times at 70° bending or a one time at 0-180° bending, the sheet resistance changes is less than 15% (FIG. 5), which is in sharp contrast to the ITO performance on a flexible substrate.

**Table 1: Accelerated aging test results for 1# samples (test conditions are 250 hours @ 60°C & 90% relative humidity)**

| Sample | Before Accelerated Aging Test | | After Accelerated Aging Test | |
|---|---|---|---|---|
| | Transmittance (%) | Sheet resistance (Ω/□) | Transmittance (%) | Sheet resistance (Ω/□) |
| Raw carbon nanotube transparent conductive thin film | 90.0 | 41 | 89.8 | 38 |

Test conditions: 250 h @60°C & 90% relative humidity

### Embodiment 2

According to this embodiment, under the protection of argon gas at a flow rate of 200ml/min, the temperature of the reactor is first increased to 1100°C, then hydrogen gas, carbon source, catalyst precursor ferrocene and growth promoter thiophene are introduced at a flow rate of 6530ml/min. Wherein the volume concentration of ethylene in the gas phase carbon source is 2.4x10⁻³ in the reaction system, the volume concentration of toluene in the reaction system is 4.4x10⁻³, and the volume concentration of the catalyst precursor ferrocene in the reaction system is 1.1x10⁻⁶, and the volume concentration of the growth promoter thiophene in the reaction system is of 3.7x10⁻⁷. The carbon nanotubes being produced flow along the gas flow to the end of the furnace tube, and is finally deposited on the porous filter positioned at the end of the furnace tube to form a macroscopic two-dimensional carbon nanotube film. Through controlling the collection time, the films with different light transmittances are obtained.

A sample of the single-walled carbon nanotube film prepared as described above is used for characterization tests of Transmission electron microscopy, sheet resistance and transmittance. Transmission electron microscopy (TEM) characterization showed that the carbon nanotubes in the film are covered with graphene islands, forming a single-walled carbon nanotube network structure welded by graphene islands. Transfer the collected carbon-welded single-walled carbon nanotube film to the flexible PET substrate by imprinting, the measured film sheet resistance of 90% transmittance (550 nm visible light) is only 50 Ω/□.

### Comparative example

Under the protection of argon gas at a flow rate of 200ml/min, the temperature of the reactor is first increased to 1100°C, then hydrogen gas, carbon source, catalyst precursor ferrocene and growth promoter thiophene are introduced at a flow rate of 4560 ml/min. Wherein the volume concentration of ethylene in the gas phase carbon source is 2.4x10⁻³ in the reaction system, the volume concentration of toluene in the reaction system is 1.1x10⁻², and the volume concentration of the catalyst precursor ferrocene in the reaction system is 2.7x10⁻⁶, and the volume concentration of the growth promoter thiophene in the reaction system is of 8.9x10⁻⁷. The carbon nanotubes being produced flow along the gas flow to the end of the furnace tube, and a macroscopic two-dimensional carbon nanotube film is formed in the porous filter positioned at the end of the furnace tube to. Through controlling the collection time, the films with different light transmittances are obtained.

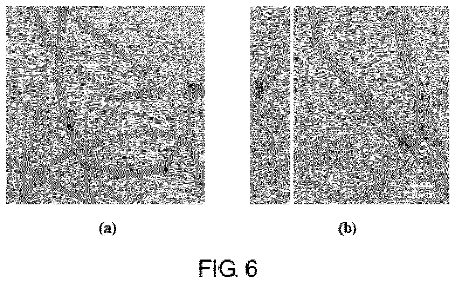

A sample of the single-walled carbon nanotube film prepared as described above (labeled as 2#) is used for characterization tests of transmission electron microscopy, sheet resistance, and transmittance. The TEM image is shown in FIG. 6, which shows that the sample is composed of bundles of 5nm ~ 40nm, and no carbon welded structure between the bundles is observed. Transfer the collected single-walled carbon nanotube film to the flexible PET substrate by imprinting, the measured film sheet resistance of 90% transmittance (550 nm visible light) is 270 Ω/□.

The results of the embodiments and the comparative example show that the present invention successfully design and prepare a graphene island welding high performance single-wall carbon nanotube network film in which the single-walled carbon nanotubes have high quality, high single tube rate, long length and large diameter, which makes the prepared transparent conductive film reach the best reported level of ITO film on the flexible substrate for the first time, that is 5.5 times of the best performance of the reported conventional carbon nanotube film without any treatment. Also, the transparent conductive film also has good chemical stability and flexibility. The present invention realizes the preparation of high-performance single-walled carbon nanotube transparent conductive film, and solves the key scientific and technical problems of poor photoelectric performance and complicated process of the conventional carbon nanotube transparent conductive film.

## Claims

1. A single-walled carbon nanotube flexible transparent conductive thin film with carbon-welded structure, wherein a highly crystalline graphene *sp²* carbon island is constructed to cover a connecting junction between single-walled carbon nanotubes, wherein the graphene *sp²* carbon island is welded at the intersection between individual single-walled carbon nanotubes, forming a single-walled carbon nanotube film having a *sp²* carbon island welded structure; in a single-walled carbon nanotube network, wherein in the single-walled carbon nanotube network, the proportion of single carbon nanotubes is 80-88%and the connecting portion of the single carbon nanotubes is tightly connected through carbon welded structure wherein a crystalline I_{G}/I_{D} of graphene carbon islands and single-walled carbon nanotubes in the carbon-welded structure is 150~180, a *sp²* C-C bond ratio is 97~99%, and an oxidation temperature exceeds 750-800°C.

2. The single-walled carbon nanotube flexible transparent conductive thin film with carbon-welded structure according to claim 1, **characterized in that**: the single-walled carbon nanotubes have a length of 10~ 200µm and a diameter of 1.4~2.4nm.

3. A preparation method of the single-walled carbon nanotube flexible transparent conductive thin film with carbon-welded structure according to claim 1 or 2, **characterized in that**: using volatile metal organic compound ferrocene as a catalyst precursor, sulfur-containing organic compound thiophene as a growth promoter, hydrocarbon ethylene and toluene as carbon source, hydrogen as a carrier gas, growing carbon nanotubes under 1100°C in a reaction furnace, and collecting in situ high-quality single-walled carbon nanotube flexible transparent conductive thin film at the end of a furnace tube of the reaction furnace wherein ethylene is mixed with carrier gas hydrogen and toluene being mixed with ferrocene and thiophene,
the preparation method comprising the steps of:
(1) under argon gas protection, first increasing a temperature of the reactor furnace to 1100±50°C, then introducing a carrier gas hydrogen and a main carbon source ethylene;
(2) being carried by a carrier gas, supplying a solution consisting of auxiliary carbon source toluene, catalyst precursor ferrocene and growth promoter thiophene by an injection pump, the solution being volatilized and entered into a 1100±50°C high temperature zone; cleaveing ferrocene and thiophene to form catalyst particles, cracking ethylene and toluene to carbon atoms under catalysis of the catalyst, and nucleating on the catalyst particles to grow single-walled carbon nanotubes; and
(3) the single-walled carbon nanotubes flowing along a gas flow to the end of the furnace tube, and finally being filtered by a porous filter positioned at the end of the furnace tube to form a macroscopic two-dimensional carbon nanotube thin film wherein in the process of growing single-walled carbon nanotubes by floating catalyst chemical vapor deposition, through reducing a concentration of the catalyst and the carbon source and a staying time in a constant temperature zone, forming *sp²* carbon islands by a portion of carbon source which is decomposed by the catalyst, welding at an intersection between individual single-walled carbon nanotubes by the carbon islands such that a single-walled carbon nanotube film having a *sp²* carbon island welded structure is finally formed; before and after the preparation method, a flow rate of argon gas is 180~220 ml/min; during the preparation method, a flow rate of hydrogen is 4500~8000ml/min, a flow rate of ethylene is 2~20ml/min, and a supply rate of the solution is 0.1 ~ 0.24ml/hr, the solution is toluene: ferrocene: thiophene = 10g: (0.05~0.6)g: (0.025~0.9)g.

4. The preparation method of single-walled carbon nanotube flexible transparent conductive thin film with carbon-welded structure according to claim 3, **characterized in that**: an imprinting method is used to transfer the carbon nanotube thin film to a flexible substrate to construct the single-walled carbon nanotube flexible transparent conductive thin film.

5. The preparation method of single-walled carbon nanotube flexible transparent conductive thin film with carbon-welded structure according to claim 4, **characterized in that**: the flexible substrate is polyethylene terephthalate, polyethylene naphthalate or polycarbonate.

## Patentansprüche

1. Flexible transparente leifähige Dünnschicht aus einwandigen Kohlenstoffnanorörchen mit geschweißter Kohlenstoffstruktur, wobei eine hochkristalline *sp*²-Graphenkohlenstoffinsel zur Abdeckung eines verbindenden Anschlusses zwischen einwandigen Kohlenstoffnanorörchen aufgebaut ist, wobei die *sp*²-Graphenkohlenstoffinsel an der Schnittstelle zwischen einzelnen einwandigen Kohlenstoffnanorörchen geschweißt ist, wodurch eine Dünnschicht aus einwandigen Kohlenstoffnanorörchen mit geschweißter *sp²-*Kohlenstoffstruktur gebildet wird; in einem einwandigen Kohlenstoffnanorörchennetzwerk, wobei in dem einwandigen Kohlenstoffnanorörchennetzwerk, das Verhältnis der einzelnen Kohlenstoffnanorörchen 80-88 % ist und das verbindende Teil der einzelnen Kohlenstoffnanorörchen dicht über die geschweißte Kohlenstoffstruktur verbunden ist, wobei ein kristallines Verhältnis der Intensitäten I_{G}/I_{D} von Graphenkohlenstoffinseln und von einwandigen Kohlenstoffnanorörchen in der geschweißter Kohlenstoffstruktur 150 - 180 ist, eine *sp*²-C-C-Bindungsverhältnis 97 - 99 % ist, und eine Oxidationstemperatur 750 -800°C überschreitet.

2. Flexible transparente leifähige Dünnschicht aus einwandigen Kohlenstoffnanorörchen mit geschweißter Kohlenstoffstruktur nach Anspruch 1 **dadurch gekennzeichnet, dass** die Kohlenstoffnanorörchen eine Länge von 10 - 200 µm und einen Durchmesser von 1,4 - 2,4 nm aufweisen.

3. Herstellungsverfahren der flexible transparente leifähige Dünnschicht aus einwandigen Kohlenstoffnanorörchen mit geschweißter Kohlenstoffstruktur nach Anspruch 1 oder Anspruch 2 **dadurch gekennzeichnet, dass** man eine flüchtige organische Verbindung Ferrocen als Katalysatorvorläufer, eine Schwefel enthaltende Verbindung Thiophen als Wachstumsförderer, Kohlenwasserstoffethylen und Toluol als Kohlenstoffquellen, Wasserstoff als Trägergas verwendet, man Kohlenstoffnanorörchen unter 1100 °C in einem Reaktionsofen wachsen läßt, man am Ort am Ende eines Ofenrohrs einwandige flexible transparente leitfähige Hochqualitätsdünnschicht aus einwandigen Kohlenstoffnanorörchen sammelt, wobei Ethylen mit dem Trägergas Wasserstoff vermischt wird und Toluol mit Ferrocen und Thiophen vermischt wird,
wobei das Herstellungsverfahren die folgenden Schritte umfasst:
(1) unter Argongasschutz, erhöht man eine Reaktorofentemperatur zu 1100 ± 50°C, dann führt man einen Trägergas Wasserstoff und eine Kohlenstoffhauptquelle Ethylen ein;
(2) man versorgt mittels einer Einspritzpumpe eine von einem Trägergas getragene Lösung bestehend aus einer Hilfskohlenstoffquelle Toluol, einem Katalysatorvorläufer Ferrocen und aus einem Wachstumsförderer Thiophen, wobei die Lösung verflüchtigt wird und in einen Hochtemperaturbereich 1100 ± 50 °C eingelassen wird; man spaltet Ferrocen und Thiophen zur Bildung von Katalysatorpartikeln, man krackt Ethylen und Toluol unter Katalyse des Katalysators zu Kohlenstoffatomen, man bildet Keime auf den Katalysatorpartikeln zum Wachsen von einwandigen Kohlenstoffnanorörchen, und
(3) die einwandigen Kohlenstoffnanorörchen strömen den Gasstrom entlang zum Ende des Ofenrohrs, und werden von einem porösen Filter gefiltert, der am Ende des Ofenrohrs zur Bildung einer makroskopischen zweidimensionalen Kohlenstoffdünnschicht gelegen ist, wobei in dem Prozess des Wachstums von einwandigen Kohlenstoffnanorörchen mittels der chemischen Gasphasenabscheidung des schwebenden Katalysators, bei der man eine Konzentration des Katalysators und der Kohlenstoffquelle und eine Verbleibzeit in einem konstanten Temperaturbereich vermindert, *sp*²-Kohlenstoffinsel von einem Teil der Kohlenstoffquelle, das von dem Katalysator zerfallen wurde, gebildet werden, einzelne einwandige Kohlenstoffnanorörcheninsel einander an einer Schnittstelle zwischen einzelnen einwandigen Kohlenstoffnanorörchen so schweißen, dass eine einwandige Kohlenstoffnanorörchendünnschicht mit geschweißter *sp*²-Kohlenstoffinselstruktur endlich gebildet wird; vor und nach dem Herstellungsverfahren ein Durchsatz von Argongas 180 - 220 ml/min beträgt, während des Herstellungsverfahrens ein Wasserstoffdurchsatz 4500 - 8000 l/min ist, ein Ethylendurchsatz 2 - 20 ml/min beträgt, eine Versorgungsrate der Lösung 0,1 - 0,24 ml/Stunde beträgt, die Lösung aus Toluol: Ferrocen: Thiophen in den Verhältnissen = 10 g: (0,05 - 0,6) g: (0,025 - 0,6) g: (0,025 - 0,9) g.

4. Herstellungsverfahren der flexible transparente leifähige Dünnschicht aus einwandigen Kohlenstoffnanorörchen mit geschweißter Kohlenstoffstruktur nach Anspruch 3 **dadurch gekennzeichnet, dass** ein Druckverfahren zur Übertragung der Kohlenstoffnanorörchendünnschicht zu einem flexiblen Substrat benutzt wird, damit die flexible transparente leitfähige Dünnschicht aus einwandigen Kohlenstoffnanorörchen aufgebaut wird.

5. Herstellungsverfahren der flexible transparente leifähige Dünnschicht aus einwandigen Kohlenstoffnanorörchen mit geschweißter Kohlenstoffstruktur nach Anspruch 4 **dadurch gekennzeichnet, dass** das flexible Substrat Polyethylenterephthalat, Polyethylennaphthalat, oder Polycarbonat ist.

## Revendications

1. Film mince conducteur transparent flexible constitué de nanotubes de carbone monoparoi avec structure soudée au carbone, dans lequel un îlot de carbone *sp²* formé de graphène hautement cristallin est conçu afin de couvrir une jonction de raccordement entre des nanotubes de carbone monoparoi, dans lequel l'îlot de carbone *sp²* formée de graphène est soudée à l'intersection entre les nanotubes de carbone monoparoi individuels, ce qui forme un film de nanotubes de carbone monoparoi présentant une structure soudée en îlot de carbone *sp²* ; dans un réseau de nanotubes de carbone monoparoi, où dans le réseau de nanotubes de carbone monoparoi la proportion de nanotubes de carbone individuels est de 80 - 88 % et la partie de raccordement des nanotubes de carbone est raccordée de façon serrée par l'intermédiaire d'une structure de carbone soudée, une proportion cristalline des intensités I_{G}/I_{D} étant de 150 -180, une proportion des liaisons C-C *sp²* est de 97-99 %, et une température d'oxydation excède 750-800 °C.

2. Film mince conducteur transparent flexible constitué de nanotubes de carbone monoparoi avec structure soudée au carbone selon la revendication 1, **caractérisé en ce que** les nanotubes de carbone monoparoi présentent une longueur de 10 - 200 µm et un diamètre de 1,4 - 2,4 nm.

3. Procédé de préparation du film mince conducteur transparent flexible constitué de nanotubes de carbone monoparoi avec structure soudée au carbone selon la revendication 1 ou la revendication 2, **caractérisé en ce que** l'on utilise le composé organométallique volatil ferrocène en tant que précurseur de catalyseur, un composé organique contenant du soufre, le thiophène, en tant que promoteur de croissance, l'éthylène hydrocarboné et le toluène comme sources de carbone, l'hydrogène comme gaz porteur, **en ce que** l'on fait croître des nanotubes de carbone à 1100 °C dans un four de réaction, et que l'on collecte sur place à l'extrémité d'un tube de four du four de réaction un film mince conducteur transparent flexible constitué de nanotubes de carbone monoparoi de grande qualité, où l'éthylène est mélangé au gaz transporteur hydrogène, et le toluène est mélangé aux ferrocène et thiophène,
le procédé de préparation comprenant les étapes de :
(1) sous protection de gaz argon augmenter dans un premier temps la température du four de réaction à 1100 ± 50 °C, ensuite introduire un gaz porteur l'hydrogène et une source principale de carbone l'éthylène ;
(2) Etant transportée par un gaz porteur, une solution constituée d'une source de carbone auxiliaire toluène, d'un précurseur de catalyseur ferrocène et d'un promoteur de croissance thiophène est amenée au moyen d'une pompe d'injection, la solution se volatilise et pénètre une zone de haute température à 1100 ± 50 °C, le ferrocène et le thiophène sont fendus pour former des particules de catalyseur, l'éthylène et le toluène sont craqués en atomes de carbone par l'action catalytique du catalyseur, et une nucléation sur les particules de catalyseur est effectuée afin de faire croître des nanotubes de carbone monoparoi, et
(3) les nanotubes de carbone monoparoi s'écoulent le long d'un flux gazeux vers l'extrémité du tube de four, et sont finalement filtrés par un filtre poreux situé à l'extrémité du tube de four afin de former un mince film de nanotubes de carbone bidimensionnel macroscopique, où dans le processus de croissance des nanotubes de carbone monoparoi par dépôt chimique en phase vapeur de catalyseur flottant, en réduisant une concentration du catalyseur et de la source de carbone et d'une durée de séjour dans une zone de température constante, des îlots de carbone *sp²* sont formés par une partie de la source de carbone qui est décomposée par le catalyseur, les îlots de carbone soudent à une intersection entre les nanotubes de carbone monoparoi individuels de sorte qu'un film de nanotubes de carbone monoparoi présentant une structure soudée par îlots de carbone *sp²* est finalement formée ; en amont et en aval du procédé de préparation, un débit de gaz argon est de 180 - 220 ml/min ; pendant le procédé de préparation le débit d'hydrogène est de 4500 - 8000 ml/min, un débit d'éthylène est de 2 - 20 ml/min, et le taux d'alimentation en solution est de 0,1 ~ 0,24 ml/hr, la solution comprend du toluène, du ferrocène et du thiophène dans les proportions 10 g : (0,05 ~ 0,6) g : (0,025 ~ 0,9) g.

4. Procédé de préparation du film mince conducteur transparent flexible constitué de nanotubes de carbone monoparoi avec structure soudée au carbone selon la revendication 3, **caractérisé en ce qu'**un procédé d'impression est utilisé pour transférer le film mince de nanotubes de carbone à un substrat flexible afin de concevoir le film mince conducteur transparent flexible constitué de nanotubes de carbone monoparoi.

5. Procédé de préparation du film mince conducteur transparent flexible constitué de nanotubes de carbone monoparoi avec structure soudée au carbone selon la revendication 4, **caractérisé en ce que** le substrat flexible est un polyéthylène téréphtalate, un polyéthylène naphtalate ou un polycarbonate.
